# DEMANDE DE BREVET EUROPEEN

(11) **EP 3 478 041 A1**
(43) Date de publication de la demande: **01.05.2019**
(21) Numéro de dépôt: 18202536.1
(22) Date de dépôt: 25.10.2018
(51) Int. Cl.: H05K 5/06, B60Q 1/00

(54) **BOITIER POUR CARTE ELECTRONIQUE POUR DISPOSITIF LUMINEUX POUR VEHICULE AUTOMOBILE**

(30) Priorité: 25.10.2017 FR 1760076
(71) Demandeur: Valeo Vision, 93012 Bobigny Cedex (FR)
(72) Inventeur: BADIA, Olivier, 93012 BOBIGNY Cedex (FR)
(74) Mandataire: Valeo Vision

(57) **Abrégé**

L'invention concerne un boîtier (1) pour carte électronique (10) pour dispositif lumineux pour véhicule automobile. Ledit boîtier (1) comporte :
- un capot de protection (11) adapté pour être disposé sur un dissipateur thermique (12) ;
- ledit dissipateur thermique (12) étant adapté pour accueillir ladite carte électronique (10) ;
- un joint d'étanchéité primaire (13) disposé entre ledit capot de protection (11) et ledit dissipateur thermique (12) à proximité du pourtour (121) du dissipateur thermique (12) ; et
- un dispositif de protection (120) dudit joint d'étanchéité primaire (13).

## Description

### DOMAINE TECHNIQUE DE L'INVENTION

La présente invention concerne un boîtier pour carte électronique pour dispositif lumineux pour véhicule automobile.

L'invention trouve une application particulière mais non limitative dans le domaine des dispositifs de pilotage de l'alimentation électrique d'une source lumineuse.

### ARRIÈRE-PLAN TECHNOLOGIQUE DE L'INVENTION

Un boîtier pour carte électronique pour dispositif lumineux pour véhicule automobile comprend de manière connue de l'homme du métier :
- un capot de protection adapté pour fermer ledit boîtier ; et
- un dissipateur thermique adapté pour évacuer la chaleur dégagée par les composants électroniques de la carte électronique.
Le dispositif lumineux comprend au moins une source lumineuse. La carte électronique comprend au moins un composant électronique de pilotage de l'alimentation électrique de ladite source lumineuse. Elle est disposée entre le dissipateur thermique et le capot de protection dudit boîtier.
Ledit boîtier pour carte électronique est assemblé sur un boîtier secondaire pour dispositif lumineux.
Un muret de protection sur le boîtier secondaire fait le tour du boîtier pour carte électronique de sorte à protéger la zone d'assemblage entre le capot de protection et le dissipateur thermique. Le muret de protection longe le pourtour du dissipateur thermique avec un jeu d'assemblage de quelques dixièmes de millimètres entre le muret de protection et ledit dissipateur thermique. Le composant électronique de pilotage est ainsi confiné par ledit muret de protection côté boîtier secondaire. Cela permet d'assurer l'étanchéité des composants électroniques de la carte électronique, en particulier dudit composant électronique de pilotage, contre des agressions d'un fluide sous pression.

Un inconvénient de cet état de la technique antérieur est que ce confinement créé des conditions thermiques défavorables. En conséquence, la chaleur dégagée notamment par les composants électroniques de la carte électronique n'est pas suffisamment dissipée.

Dans ce contexte, la présente invention vise à résoudre l'inconvénient précédemment mentionné.

### DESCRIPTION GENERALE DE L'INVENTION

A cette fin l'invention propose un boîtier pour carte électronique pour dispositif lumineux pour véhicule automobile, ledit boîtier comportant ;
- un capot de protection adapté pour être disposé sur un dissipateur thermique ;
- ledit dissipateur thermique adapté pour accueillir ladite carte électronique ;
- un joint d'étanchéité primaire disposé entre ledit capot de protection et ledit dissipateur thermique à proximité du pourtour du dissipateur thermique ; et
- un dispositif de protection dudit joint d'étanchéité primaire.

Ainsi, comme on va le voir en détail ci-après, le dispositif de protection est adapté pour protéger le joint d'étanchéité primaire, disposé entre le capot de protection et le dissipateur thermique, contre les agressions d'un fluide sous pression dirigé vers ledit boîtier, par exemple de l'eau sous pression. En effet, un tel fluide sous pression serait susceptible d'abîmer le joint d'étanchéité et d'altérer à terme le fonctionnement de ce joint d'étanchéité. De plus, le dispositif de protection est disposé de sorte à permettre un flux d'air de venir directement en contact avec le capot de protection pour favoriser l'évacuation de la chaleur hors du boîtier pour carte électronique.

Selon des modes de réalisation non limitatifs, le boîtier pour carte électronique peut comporter en outre une ou plusieurs caractéristiques supplémentaires parmi les suivantes :
Selon un mode de réalisation non limitatif, ledit capot de protection comprend une ouverture du côté opposé au dissipateur thermique de sorte à recevoir un connecteur.

Selon un mode de réalisation non limitatif, ledit capot de protection comprend un joint d'étanchéité secondaire disposé côté de ladite ouverture.

Selon un mode de réalisation non limitatif, ledit dispositif de protection comprend au moins un muret agencé sur au moins une partie du pourtour dudit dissipateur thermique.

Selon un mode de réalisation non limitatif, ledit au moins un muret affleure ou dépasse du capot de protection.

Selon un mode de réalisation non limitatif, ledit dispositif de protection comprend un bord tombé agencé sur ledit capot de protection et adapté pour reposer sur au moins une partie du pourtour dudit dissipateur thermique.

Selon un mode de réalisation non limitatif, ledit dissipateur thermique et/ou ledit capot de protection est plan ou comprend des protubérances.

Il est également proposé un dispositif de pilotage de l'alimentation électrique pour au moins une source lumineuse pour dispositif lumineux, dans lequel ledit dispositif de pilotage comprend un boîtier selon l'une quelconque des caractéristiques précédentes et une carte électronique logée dans ledit boîtier.

Il est également proposé un assemblage pour dispositif lumineux pour véhicule automobile comprenant un boîtier pour carte électronique selon l'une quelconque des caractéristiques précédentes assemblé avec un boîtier secondaire pour dispositif lumineux.

Selon un mode de réalisation non limitatif, ledit boîtier secondaire comprend au moins un dispositif de fixation pour ledit boîtier.

Selon un mode de réalisation non limitatif, ledit boîtier secondaire comprend au moins un dispositif d'appui pour ledit boîtier.

Selon un mode de réalisation non limitatif, ledit boîtier secondaire comprend au moins un dispositif de guidage pour ledit boîtier.

Selon un mode de réalisation non limitatif, ledit au moins un dispositif de guidage est une nervure.

Selon un mode de réalisation non limitatif, ledit au moins un dispositif de guidage est une gouttière.

Selon un mode de réalisation non limitatif, ledit boîtier secondaire comprend un muret de protection disposé à distance du pourtour dudit dissipateur thermique du boîtier pour carte électronique.

Selon un mode de réalisation non limitatif, ledit muret de protection se trouve à une distance comprise sensiblement entre 5mm et 10mm du pourtour du dissipateur thermique.

Il est également proposé un dispositif lumineux pour véhicule automobile, dans lequel ledit dispositif lumineux comprend :
- au moins une source lumineuse adaptée pour produire des rayons lumineux ;
- un module optique adapté pour coopérer avec lesdits rayons lumineux de ladite au moins une source lumineuse ;
- un boîtier pour carte électronique selon l'une quelconque des caractéristiques précédentes ;
- une carte électronique logée dans ledit boîtier ; et
- un boîtier secondaire adapté pour être assemblé avec ledit boîtier pour carte électronique.

### BREVE DESCRIPTION DES FIGURES

L'invention et ses différentes applications seront mieux comprises à la lecture de la description qui suit et à l'examen des figures qui l'accompagnent.
- la figure 1 représente une vue éclatée d'un boîtier pour carte électronique pour dispositif lumineux selon un mode de réalisation non limitatif, ledit boîtier comprenant un capot de protection et un dissipateur thermique ;
- la figure 2 représente le boîtier de la figure 1 dans lequel est logée une carte électronique et qui coopère avec un connecteur d'un faisceau d'alimentation ;
- la figure 3 représente une vue de dessus d'une perspective partielle du dissipateur thermique du boitier de la figure 1, selon un mode de réalisation non limitatif ;
- la figure 4 représente une vue de dessous d'une perspective du dissipateur thermique du boîtier de la figure 1, selon un mode de réalisation non limitatif ;
- la figure 5 représente une vue du capot de protection du boîtier de la figure 1, selon un mode de réalisation non limitatif, ledit capot de protection coopérant avec un connecteur d'un faisceau d'alimentation ;
- la figure 6 représente une vue zoomée d'une partie du dissipateur thermique de la figure 3 ;
- la figure 7 représente schématiquement une vue en coupe selon une coupe A-A du boîtier de la figure 6 avec un dispositif de protection selon une première variante de réalisation non limitative d'un premier mode de réalisation non limitatif ;
- la figure 8 représente schématiquement une vue en coupe du boîtier de la figure 1 avec un dispositif de protection selon une deuxième variante de réalisation non limitative d'un premier mode de réalisation non limitatif ;
- la figure 9 représente schématiquement une vue en coupe du boîtier de la figure 1 avec un dispositif de protection selon un deuxième mode de réalisation non limitatif;
- la figure 10 représente une vue en perspective d'un assemblage pour dispositif lumineux pour véhicule automobile comprenant le boîtier de la figure 1 et un boîtier secondaire selon un premier mode de réalisation non limitatif ;
- la figure 11 représente une vue éclatée de l'assemblage de la figure 10, selon un mode de réalisation non limitatif ;
- la figure 12 représente une vue de dessous d'une perspective du boîtier secondaire de l'assemblage de la figure 10, selon un mode de réalisation non limitatif ;
- la figure 13 représente le boîtier secondaire de la figure 12 sur lequel est disposé le capot de protection du boîtier de la figure 1, selon un mode de réalisation non limitatif ;
- la figure 14 représente une vue en perspective d'un assemblage pour dispositif lumineux pour véhicule automobile comprenant le boîtier de la figure 1 et un boîtier secondaire selon un deuxième mode de réalisation non limitatif ;
- la figure 15 représente une vue de dessous d'une perspective du boîtier secondaire de l'assemblage de la figure 14, selon un mode de réalisation non limitatif ;
- la figure 16 représente le boîtier secondaire de la figure 15 sur lequel est disposé le capot de protection du boîtier de la figure 1, selon un mode de réalisation non limitatif ;
- la figure 17 représente la figure 16 vue de profil ;
- la figure 18 représente une vue en perspective d'un assemblage pour dispositif lumineux pour véhicule automobile comprenant le boîtier de la figure 1 et un boîtier secondaire selon un troisième mode de réalisation non limitatif ;
- la figure 19 représente une vue de dessous d'une perspective du boîtier secondaire de l'assemblage de la figure 18, selon un mode de réalisation non limitatif ; et
- la figure 20 représente une vue en coupe de la figure 19.

### DESCRIPTION DE MODES DE REALISATION DE L'INVENTION

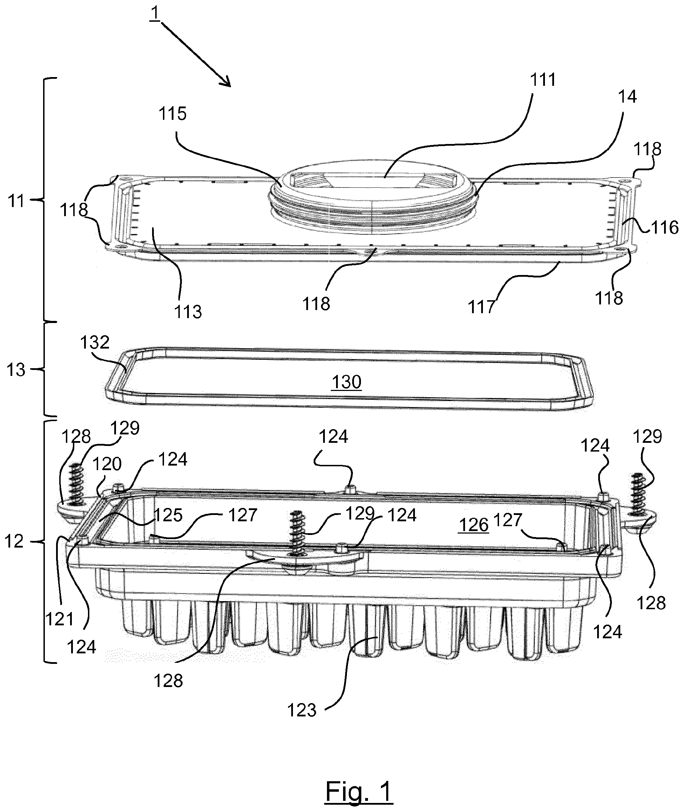

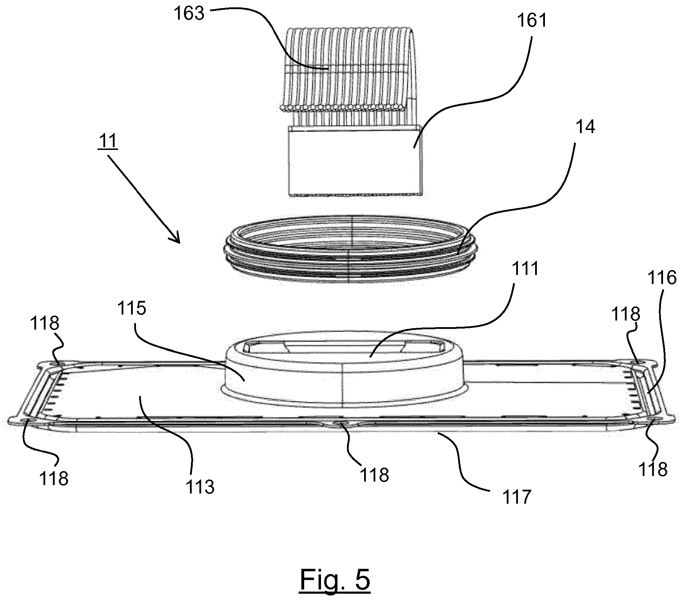

Les éléments identiques, par structure ou par fonction, apparaissant sur différentes figures conservent, sauf précision contraire, les mêmes références.
Le boitier 1 pour carte électronique 10 selon l'invention est décrit en référence aux figures 1 à 20. Dans un mode de réalisation non limitatif, ce boitier 1 avec la carte électronique 10 est adapté pour piloter l'alimentation électrique d'une source lumineuse pour un dispositif lumineux (non illustré) pour véhicule automobile.
Dans un mode de réalisation non limitatif, le dispositif lumineux est un dispositif d'éclairage et/ou de signalisation pour véhicule automobile. Dans un exemple non limitatif, le dispositif lumineux est un projecteur.
Dans un mode de réalisation non limitatif, le dispositif lumineux comprend :
- au moins une source lumineuse adaptée pour produire des rayons lumineux ;
- un module optique adapté pour coopérer avec lesdits rayons lumineux de ladite au moins une source lumineuse de sorte à produire un faisceau lumineux ;
- ledit boîtier 1 pour carte électronique 10 ;
- une carte électronique 10 logée dans le boîtier 1 ;
- un boîtier secondaire 3 adapté pour être assemblé avec le boîtier 1 pour carte électronique 10.
Dans un mode de réalisation non limitatif, ladite au moins une source lumineuse fait partie d'une diode électroluminescente.
Par diode électroluminescente, on entend tout type de diodes électroluminescentes, que ce soit dans des exemples non limitatifs des LED (« Light Emitting Diode »), une OLED (« Organic LED ») ou une AMOLED (« Active-Matrix-Organic LED »), ou encore une FOLED (« Flexible OLED »). Par véhicule automobile, on entend tout type de véhicule motorisé.
Tel qu'illustré sur les figures 1 à 14, le boitier 1 pour carte électronique 10 comporte :
- un capot de protection 11 ;
- un dissipateur thermique 12 ;
- un joint d'étanchéité primaire 13 ;
- un dispositif de protection 110, 120 dudit joint d'étanchéité primaire 13. Le boîtier 1 est adapté pour accueillir une carte électronique 10 décrite ci-après.

### • Carte électronique 10

La carte électronique 10 comprend une pluralité de composants électroniques sur au moins une de ses faces.

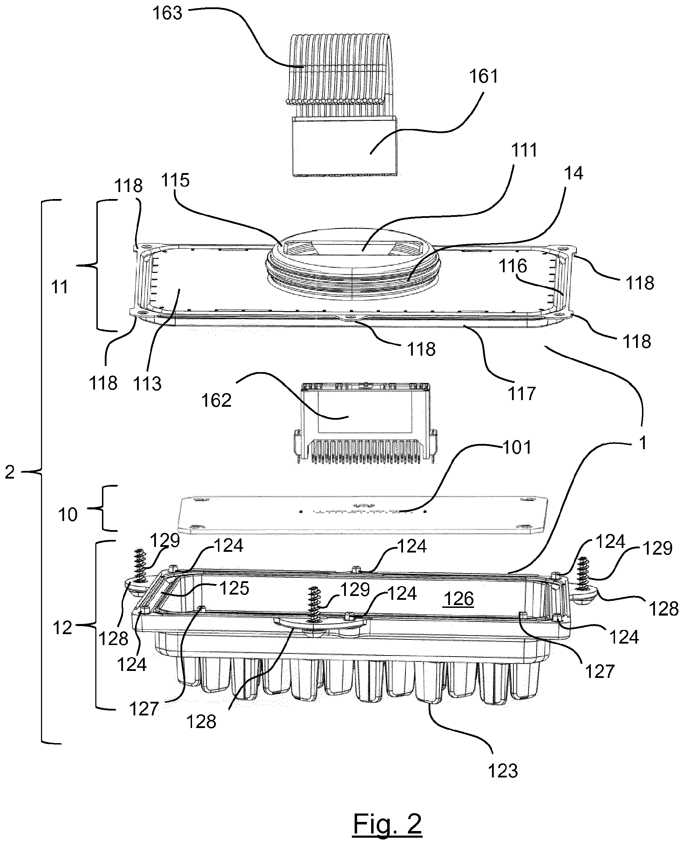

Dans un mode de réalisation non limitatif, la carte électronique 10 est une carte à circuit imprimé appelée carte PCBA (« Printed Circuit Board Assembly » en anglais). Un de ces composants électroniques est adapté pour le pilotage de l'alimentation électrique de la source lumineuse. Dans ce cas, le boîtier 1 et la carte électronique 10 logée dans ledit boîtier 1 forment un dispositif de pilotage 2 de l'alimentation électrique pour au moins une source lumineuse pour dispositif lumineux tel qu'illustré sur la figure 2. Dans un mode de réalisation non limitatif, le composant électronique de pilotage est un convertisseur DC/DC.

La carte électronique 10, et en particulier ses composants électroniques dont le composant électronique de pilotage, génèrent de la chaleur au cours de leur fonctionnement qu'il convient d'évacuer hors du boîtier 1. L'évacuation de cette chaleur est assurée par le dissipateur thermique 12 mais également par le capot de protection 11.

Les éléments du boîtier 1 sont décrits en détail ci-dessous.

### • Capot de protection 11

Le capot de protection 11 est illustré sur les figures 1, 2, 5, 7, 8, 11, 16, 17 et 20.

Le capot de protection 11 est adapté pour être disposé sur le dissipateur thermique 12 de sorte à protéger la carte électronique 10, cette dernière étant disposée entre le capot de protection 11 et le dissipateur thermique 12. Le capot de protection 11 est adapté pour être serti sur le dissipateur thermique 12.

Le capot de protection 11 est composé :
- d'une plaque de base 113 ;
- d'une cheminée primaire 115.

Dans un mode de réalisation non limitatif, le capot de protection 11 est réalisé par emboutissage ou par moulage.

Dans un premier mode de réalisation non limitatif, le capot de protection 11 est en tôle ou en aluminium injecté. Dans une variante de réalisation non limitative, la tôle est de l'acier zingué ou de l'aluminium.

Dans un deuxième mode de réalisation non limitatif, le capot de protection 11 est composé d'un matériau thermoplastique chargé en particules conductrices de chaleur. Les charges dans le matériau thermoplastique favorisent la conduction thermique de la chaleur à l'extérieur du boîtier 1. Dans une variante de réalisation non limitative, le matériau thermoplastique est chargé en graphite.

Dans un troisième mode de réalisation non limitatif, le capot de protection 11 est réalisé en Zamak, c'est-à-dire dans un alliage de zinc, d'aluminium, de magnésium et de cuivre. Cet alliage permet de réaliser en injection des pièces plus complexes et plus dures. De plus, les pièces injectées en Zamak ont une capacité de dissipation thermique identique à celle de l'aluminium. Dans un mode de réalisation non limitatif illustré sur les figures, le capot de protection 11 est plan.

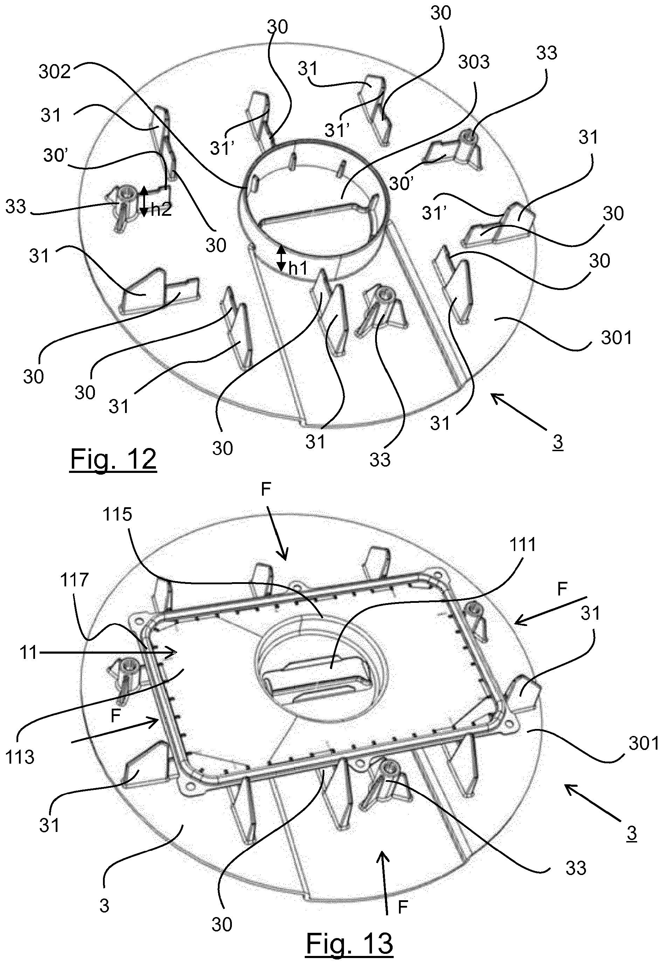

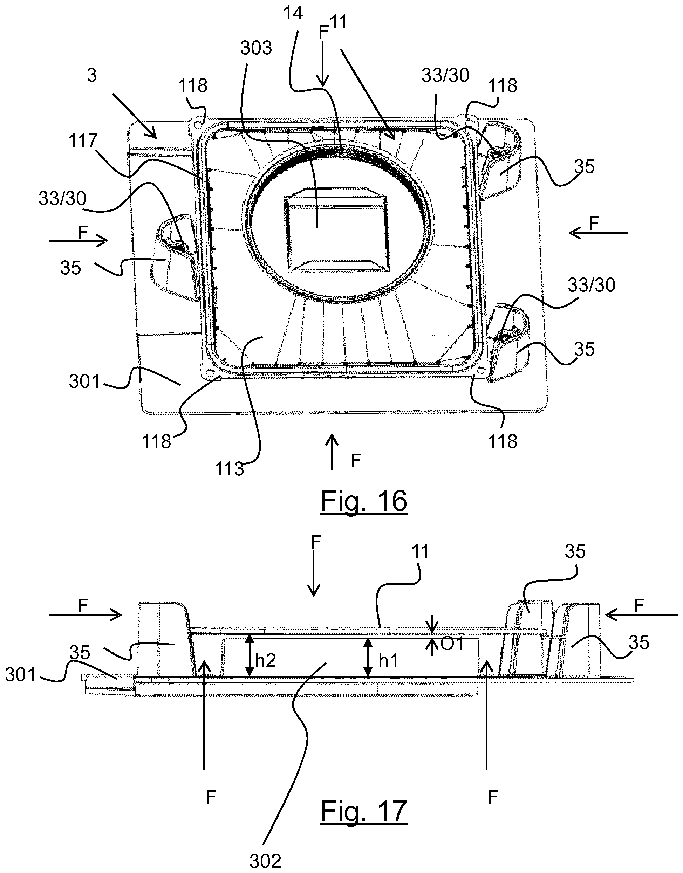

Dans un mode de réalisation non limitatif (non illustré), le capot de protection 11 comprend des protubérances, par exemple des ailettes ou des picots. Cela permet d'augmenter la surface d'échange thermique avec un flux d'air F. Un flux d'air F illustré sur la figure 13 ou 16 vient en effet en contact avec le capot de protection 11. On notera que le flux d'air F comprend une pluralité de directions fonction du positionnement du boîtier 1 sur le boîtier secondaire 3.

Dans un mode de réalisation non limitatif, le capot de protection 11 comporte un joint d'étanchéité secondaire 14. Le joint d'étanchéité secondaire 14 est disposé sur le pourtour externe de la cheminée primaire 115. Le joint d'étanchéité secondaire 14 permet de rendre étanche l'assemblage entre le capot de protection 11 et une contrepartie qui est le boîtier secondaire 3 (décrit plus loin).

### ∘ Plaque de base 113

Dans le mode de réalisation non limitatif des figures 1, 2, 5- 8, 10, 12, la plaque de base 113 est sensiblement rectangulaire. Dans le mode de réalisation non limitatif des figures 16, 17 et 20, la plaque de base 113 est sensiblement carrée.

Cette plaque de base 113 est adaptée pour fermer, au moins en partie, le boîtier 1 pour carte électronique 10.

La plaque de base113 comporte :
- une lèvre 117 ;
- au moins un dispositif de positionnement primaire 118.

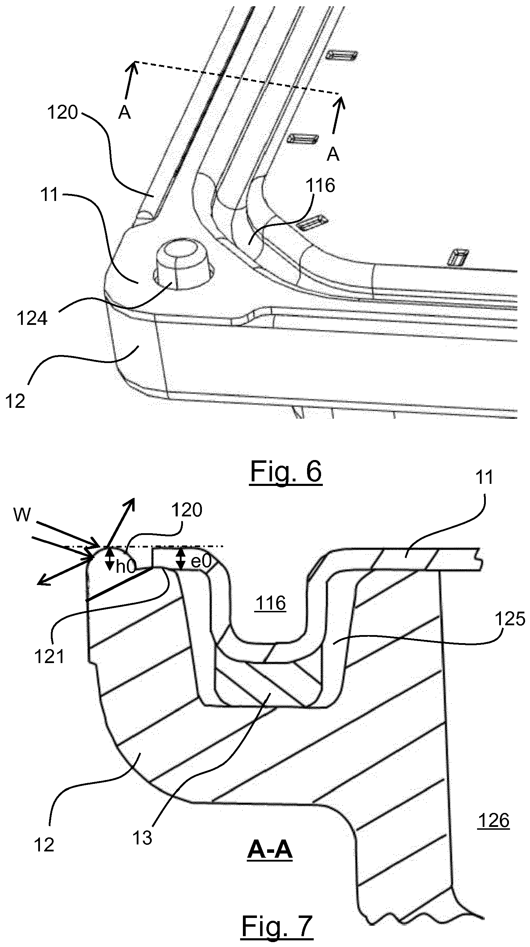

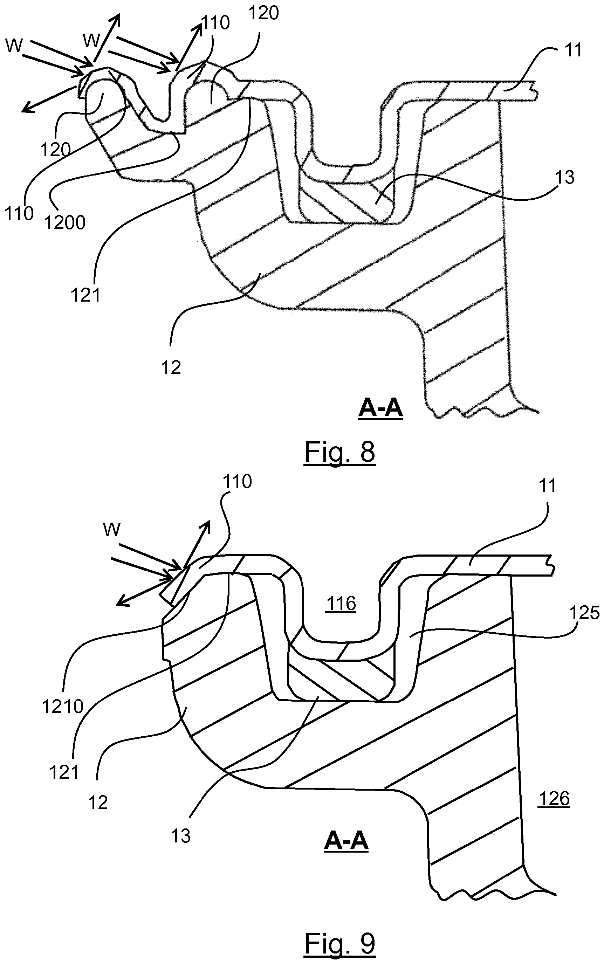

La lèvre 117 s'étend sur le pourtour de la plaque de base 113 sur une de ses faces qui se trouve en regard du dissipateur thermique 12. Cette lèvre 117 est adaptée pour maintenir le joint d'étanchéité primaire 13 entre le capot de protection 11 et le dissipateur thermique 12, lorsque le boîtier 1 est fermé, comme cela est illustré aux figures 7 et 8.

Dans un mode de réalisation non limitatif, la lèvre 117 est formée au cours d'une opération d'emboutissage de la plaque de base 113 formant une rigole 116 sur l'autre face de la plaque de base 113.

Dans un mode de réalisation non limitatif illustré sur la figure 1, la plaque de base 113 comporte six dispositifs de positionnement primaires 118. Dans un autre mode de réalisation non limitatif illustré sur la figure 16, la plaque de base 113 comporte quatre dispositifs de positionnement primaires 118.

Ces dispositifs de positionnement primaires 118 sont adaptés pour coopérer avec des dispositifs de positionnement secondaires 124 du dissipateur thermique 12 pour l'assemblage du capot de protection 11 avec ledit dissipateur thermique 12. Ils permettent le sertissage du capot de protection sur le dissipateur thermique 12. A cet effet, ils comprennent un trou de sertissage et dans un mode de réalisation non limitatif, ils font saillie à partir du pourtour de la plaque de base 113.

### ∘ Cheminée primaire 115

La cheminée primaire 115 est adaptée pour accueillir le joint d'étanchéité secondaire 14.

La cheminée primaire 115 fait protubérance à partir de la plaque de base 113. Dans le mode de réalisation des figures 1, 2, 5- 8, 10, 12, 16 et 20 la cheminée primaire 115 est placée au centre de la plaque de base 113. Elle est sensiblement cylindrique et comprend une ouverture 111. Cette ouverture 111 est disposée du côté opposé au dissipateur thermique 12 de sorte à recevoir un connecteur 16 comportant une partie mâle 162 et une partie femelle 161 illustrés sur la figure 2. La partie femelle 161 du connecteur 16 est reliée électriquement par un faisceau d'alimentation 163. L'ouverture 111 se prolonge dans la cheminée primaire 115 et elle traverse la plaque de base 113 pour permettre à la partie mâle 162 du connecteur 16 de se connecter directement à la carte électronique 10 via une zone de connexion 101 de ladite carte électronique 10.

### • Joint d'étanchéité primaire 13

Le joint d'étanchéité primaire 13 est illustré sur les figures 1, 7, 8, 9, et 20.

Le joint d'étanchéité primaire 13 est adapté pour assurer l'étanchéité entre le capot de protection 11 et le dissipateur thermique 12 lorsqu'ils sont assemblés et plus globalement pour assurer l'étanchéité du boitier 1. Il permet ainsi de protéger les composants électroniques de la carte électronique 10, en particulier le composant de pilotage de l'alimentation électrique de(s) la source(s) lumineuse(s) du dispositif lumineux.

Dans des modes de réalisation non limitatifs, le joint d'étanchéité primaire 13 est un joint en plastique, en caoutchouc, ou encore une colle polymère.

Le joint d'étanchéité primaire 13 est disposé entre le capot de protection 11 et le dissipateur thermique 12 lorsque le boîtier 1 pour carte électronique 10 est fermé.

Le joint d'étanchéité primaire 13 est adapté pour se loger dans une gorge 125 de dissipateur thermique 12 qui se situe à proximité du pourtour 121 dudit dissipateur thermique 12. Le joint d'étanchéité primaire 13 épouse la lèvre 117. Ainsi, il comprend une rigole 132 de forme complémentaire à la lèvre 117 du capot de protection 11. Le joint d'étanchéité primaire 13 est ainsi comprimé entre la lèvre 117 de la plaque de base 113 et la gorge 125 du dissipateur thermique 12 lorsque le boîtier 1 est fermé, comme cela est illustré aux figures 7, 8 et 9.

### • Dissipateur thermique 12

Le dissipateur thermique 12 est illustré sur les figures 1 à 4, 6 à 10, 14, 18 et 20.

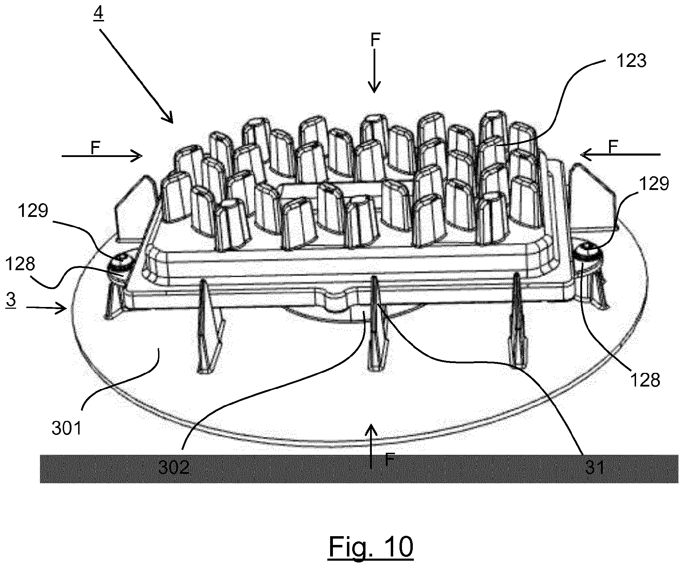

Il est adapté pour dissiper la chaleur dégagée par la carte électronique 10, notamment par ses composants électroniques. Un flux d'air F illustré sur les figures 10, 14, 16 et 17 par exemple vient en effet en contact avec le dissipateur thermique 12. On notera que c'est le même flux d'air F qui vient en contact avec le capot de protection 11. On notera que 70% à 80% de la chaleur dégagée par la carte électronique 10 peut alors être dissipée par le dissipateur thermique 12.

Dans un mode de réalisation non limitatif, le dissipateur thermique 12 est réalisé par emboutissage ou par moulage.

Dans un mode de réalisation non limitatif, le dissipateur thermique 12 est en tôle ou en aluminium injecté.

Dans un autre mode de réalisation non limitatif, le dissipateur thermique 12 est réalisé en Zamak.

Dans un autre mode de réalisation non limitatif, le dissipateur thermique 12 est composé d'un matériau thermoplastique chargé en particules conductrices de chaleur. Dans une variante de réalisation non limitative, le matériau thermoplastique est chargé en graphite.

Dans un mode de réalisation non limitatif (non illustré), le dissipateur thermique 12 est plan.

Dans un mode de réalisation non limitatif illustré sur les figures, le dissipateur thermique 12 comprend des protubérances 123, par exemple des ailettes ou des picots. Cela permet d'augmenter la surface d'échange thermique avec le flux d'air F et cela améliore ainsi l'évacuation de la chaleur hors du boîtier 1.

Dans un mode de réalisation non limitatif, les protubérances 123 sont réalisées avec le dissipateur thermique 12, au cours d'une même opération d'injection.

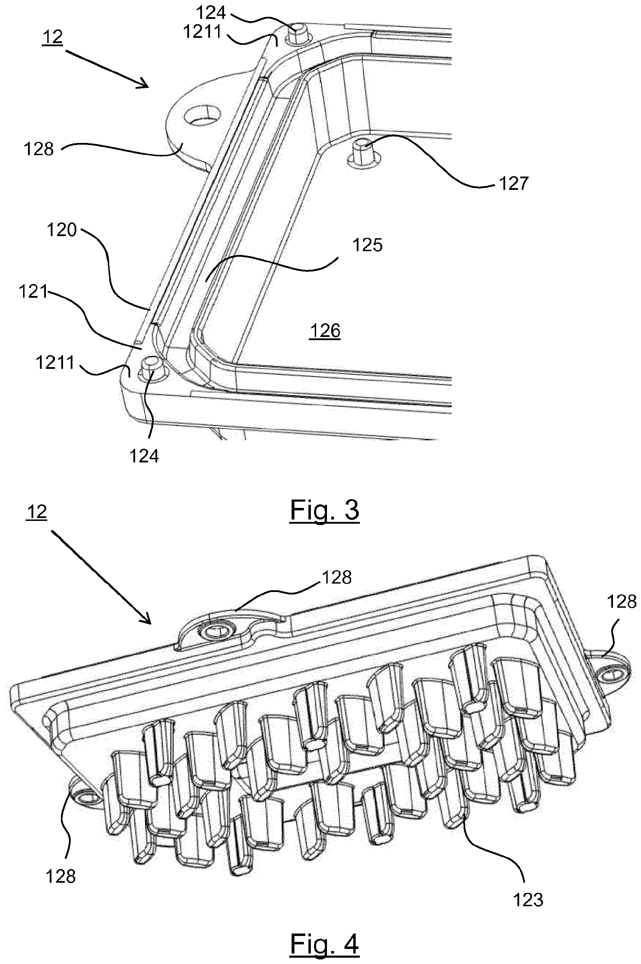

Tel qu'illustré sur la figure 3, le dissipateur thermique 12 comprend :
- un pourtour 121 ;
- une gorge 125 ;
- au moins un dispositif de positionnement secondaire 124 ;
- au moins un dispositif de fixation 128 sur le boîtier secondaire 3 (décrit plus loin).

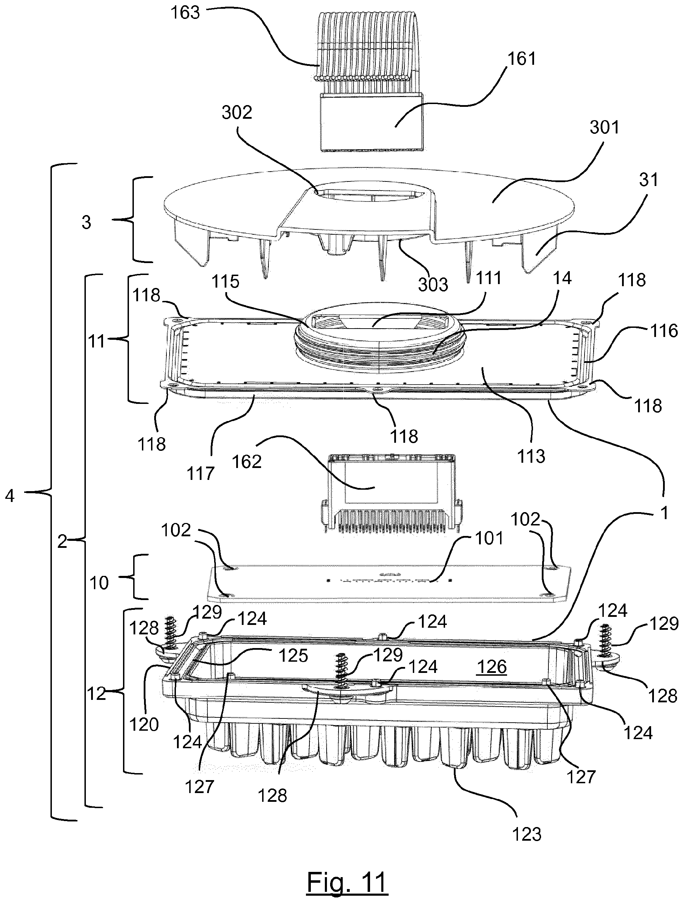

Le pourtour 121 du dissipateur thermique 12 délimite un logement central 126 adapté pour loger la carte électronique 10. Le logement central 126 comporte un fond et au moins un dispositif de positionnement primaire 127 pour la carte électronique 10 (tel qu'illustré sur les figures 2 et 11). Dans un mode de réalisation non limitatif, le dispositif de positionnement primaire 127 est un pion de sertissage. Dans un exemple non limitatif, le logement central 16 comprend deux pions de sertissage.

Les pions de sertissage 127 sont destinés à recevoir et à bloquer la carte électronique 10 dans le logement central 126. Ces pions de sertissage 127 sont adaptés pour se loger dans des trous de sertissage 102 de la carte électronique 10.

Tel que décrit précédemment, la gorge 125 est adaptée pour recevoir le joint d'étanchéité primaire 13. Elle est située à proximité du pourtour 121 dudit dissipateur thermique 12.

Dans un mode de réalisation non limitatif, ledit au moins un dispositif de positionnement secondaire 124 est un ergot adapté pour s'insérer dans un trou de sertissage 118 du capot de protection 11.

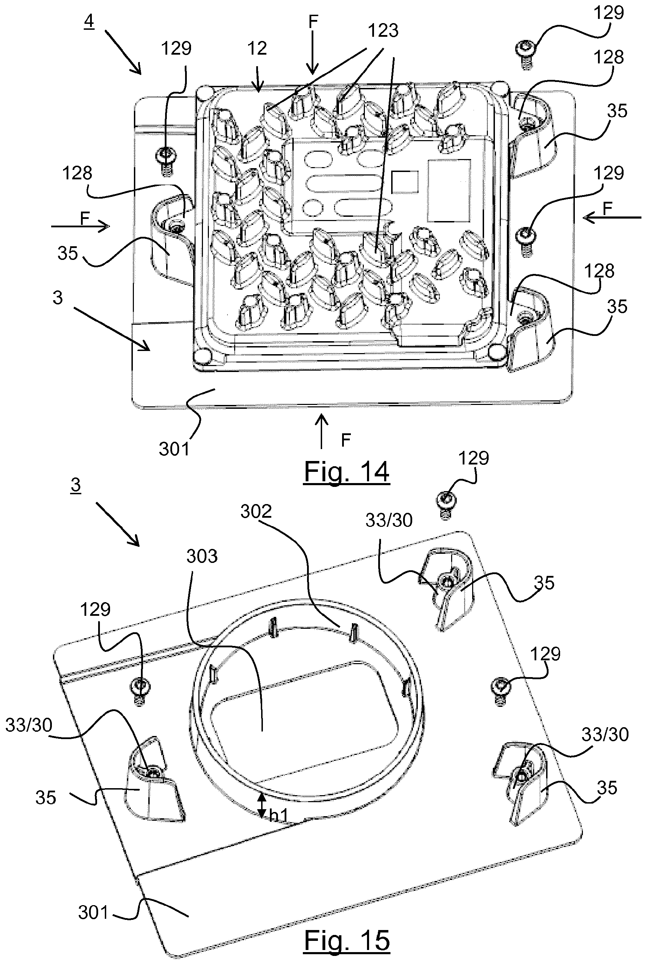

Dans un mode de réalisation non limitatif, ledit au moins un dispositif de fixation 128 est une patte de fixation ou oreille adaptée pour recevoir une vis 129. Cet ensemble patte de fixation 128-vis 129 permet le montage et le maintien du dissipateur thermique 12 sur le boîtier secondaire 3. Dans un exemple non limitatif illustré sur les figures 10 et 14, le dissipateur thermique 12 comprend trois pattes de fixation 128. Il est ainsi possible d'obtenir un assemblage 4 (décrit plus loin) pour dispositif lumineux pour véhicule automobile comprenant le boîtier 1 pour carte électronique 10 assemblé avec le boîtier secondaire 3 pour dispositif lumineux tel qu'illustré sur les figures 10 et 14.

### • Dispositif de protection 110, 120

Le dispositif de protection 110, 120 permet de protéger le joint d'étanchéité primaire 13 contre des agressions externes, de l'eau sous-pression dans un exemple non limitatif. Cette eau sous pression est utilisée pour nettoyer le compartiment moteur comprenant le dispositif lumineux et peut abîmer le joint d'étanchéité primaire 13 et par conséquent affaiblir l'étanchéité du boîtier 1. Le dispositif de protection 110, 120 permet ainsi d'assurer l'étanchéité du boîtier 1 et de protéger les composants électroniques de la carte électronique 10.

Le dispositif de protection 110, 120 est décrit selon deux modes de réalisation non limitatifs.

### ∘ Premier mode de réalisation

Dans un premier mode de réalisation non limitatif illustré aux figures 1-3, 6, 7 et 8, le dispositif de protection comprend au moins un muret 120 agencé sur au moins une partie du pourtour 121 du dissipateur thermique 12.

Dans un mode de réalisation non limitatif, le muret 120 est réalisé avec le dissipateur thermique 12, au cours d'une même opération d'injection.

Le muret 120 agit comme une barrière en déviant le flux d'eau W initialement dirigé vers le joint d'étanchéité primaire 13, comme illustré par des flèches sur la figure 7. Le joint d'étanchéité primaire 13 logé dans la gorge 125 du dissipateur thermique 12 est ainsi mieux protégé.

Dans une première variante de réalisation non limitative illustrée sur la figure 6, le muret 120 ne s'étend que sur une partie du pourtour 121 du dissipateur thermique 12, là où le flux d'eau W sous pression peut facilement accéder. Ainsi, le muret 120 ne s'étend pas sur les coins 1211 du pourtour 121, ces derniers étant moins exposés aux flux d'eau W sous pression.

Dans une seconde variante de réalisation non limitative (non illustrée), le muret 120 s'étend sur l'ensemble du pourtour 121 du dissipateur thermique 12. Ainsi, le muret 120 s'étend également sur les coins 1211 du pourtour 121 du dissipateur thermique 12.

Dans un mode de réalisation non limitatif illustré, le muret 120 présente une forme dépouillée arrondie. C'est une forme facile à réaliser par moulage. Dans une variante de réalisation non limitative illustrée, cette forme dépouillée arrondie est un demi-disque.

Dans une première variante de réalisation non limitative illustrée sur la vue en coupe de la figure 7, le dispositif de protection comprend un seul muret 120 agencé sur au moins une partie du pourtour 121 du dispositif thermique 12. Dans un mode de réalisation non limitatif de cette première variante illustré sur la figure 7, le muret 120 affleure du capot de protection 11. Cela permet d'avoir un encombrement minimum du boîtier 1. A la figure 7, on voit ainsi que la partie supérieure du muret 120 est au même niveau que le capot de protection 11. Autrement dit, la hauteur h0 du muret 120 correspond à une épaisseur e0 du capot de protection 11. Dans un mode de réalisation non limitatif, l'épaisseur e0 est comprise sensiblement entre 0,5mm (millimètres) et 1mm.

Dans un autre mode de réalisation non limitatif (non illustré) de cette première variante, le muret 120 dépasse du capot de protection 11. Autrement dit, la hauteur h0 du muret 120 est supérieure à l'épaisseur e0 du capot de protection 11. On améliore ainsi la protection du joint d'étanchéité 13 par le muret 120.

Dans une deuxième variante de réalisation non limitative illustrée sur la vue en coupe de la figure 8, le dispositif de protection comprend deux murets 120 agencés sur au moins une partie du pourtour 121 du dispositif thermique 12. Dans un mode de réalisation de cette variante, le bord 110 du capot de protection 11 se prolonge de sorte à recouvrir les deux murets 120. En particulier, tel qu'illustré, le bord 110 épouse la forme des deux murets et la jonction 1200 entre les deux murets 120. Dans un autre mode de réalisation de cette variante (non illustré), le capot de protection 11 comprend un bord 110 qui se prolonge de sorte à recouvrir les deux murets 120 et un bord tombé intermédiaire qui forme une nervure et recouvre le muret 120 le plus proche du pourtour 121 du dissipateur thermique 12.

### ∘ Deuxième mode de réalisation

Dans un deuxième mode de réalisation non limitatif illustré à la figure 9, le dispositif de protection comprend un bord tombé 110 agencé sur le capot de protection 11.

Ce bord tombé 110 est adapté pour reposer sur au moins une partie 1210 du pourtour 121 du dissipateur thermique 12. Dans un mode de réalisation non limitatif, cette partie 1210 du pourtour 121 est inclinée. Ainsi, le bord tombé 110 en s'appuyant sur la partie 1210 du pourtour 121 vient fermer la gorge 125 du dissipateur thermique 12 dans laquelle est logé le joint d'étanchéité 13. Le bord tombé 110 agit comme une barrière en déviant le flux d'eau W initialement dirigé vers le joint d'étanchéité primaire 13, comme illustré par des flèches sur la figure 9. Le joint d'étanchéité primaire 13 logé dans la gorge 125 du dissipateur thermique 12 est ainsi mieux protégé.

### • Assemblage 4

L'assemblage 4 est illustré sur les figures 10 et 14 selon deux modes de réalisation non limitatifs.

L'assemblage 4 comprend le boîtier 1 pour carte électronique 10 décrit précédemment assemblé avec un boîtier secondaire 3.

Lorsque le dispositif lumineux est un projecteur avant pour véhicule automobile dans un mode de réalisation non limitatif, le boîtier secondaire 3 est appelé boîtier projecteur.

Dans des modes de réalisation non limitatifs, le boîtier 1 pour carte électronique 10 peut être assemblé avec le boîtier secondaire 3 sur sa face arrière, sur le dessous ou sur un de ses côtés. La face avant du boîtier secondaire 3 permet au faisceau lumineux du dispositif lumineux de réaliser sa fonction d'éclairement.

Dans un mode de réalisation non limitatif, le boîtier secondaire 3 est réalisé dans un matériau plastique.

Le boîtier secondaire 3 est composé :
- d'un corps de base 301 ; et
- d'une cheminée secondaire 302.

Le corps de base 301 est adapté pour accueillir le dispositif de pilotage 2 de l'alimentation électrique, c'est-à-dire le boîtier 1 et la carte électronique 10. La cheminée secondaire 302 est adaptée pour recevoir la cheminée primaire 115 du capot de protection 11, cette dernière s'emboîtant à l'intérieur de ladite cheminée secondaire 302. Le joint d'étanchéité secondaire 14 est alors comprimé entre la cheminée primaire 115 et la cheminée secondaire 302 afin de rendre étanche la liaison entre la cheminée 115 et la cheminée secondaire 302. Ainsi, l'assemblage 4 est rendu étanche. La cheminée secondaire 302 comprend une ouverture 303 (illustrée sur la figure 12 ou 15) qui s'étend jusqu'au corps de base 301. Cette ouverture 303 est en vis-à-vis avec l'ouverture 111 de la cheminée primaire 115. Par ces ouvertures 111, 303, il est possible de faire passer la partie femelle 161 du connecteur 16 afin de la connecter avec la partie mâle 162 de ce même connecteur 16, ladite partie mâle 162 étant logée dans le boîtier 1.

La cheminée secondaire 302 comprend une hauteur h1 suffisante pour accueillir le joint d'étanchéité secondaire 14.

Le boîtier secondaire 3 comprend (disposés sur le corps de base 301) :
- au moins un dispositif de guidage 31, 35 pour le boîtier 1 ;
- au moins un dispositif de fixation 33 pour le boîtier 1 ;
- au moins un dispositif d'appui 30, 30' pour le boîtier 1.

Dans un premier mode de réalisation non limitatif illustré sur les figures 10 à 17, le boîtier secondaire 3 ne comporte aucun muret de protection.

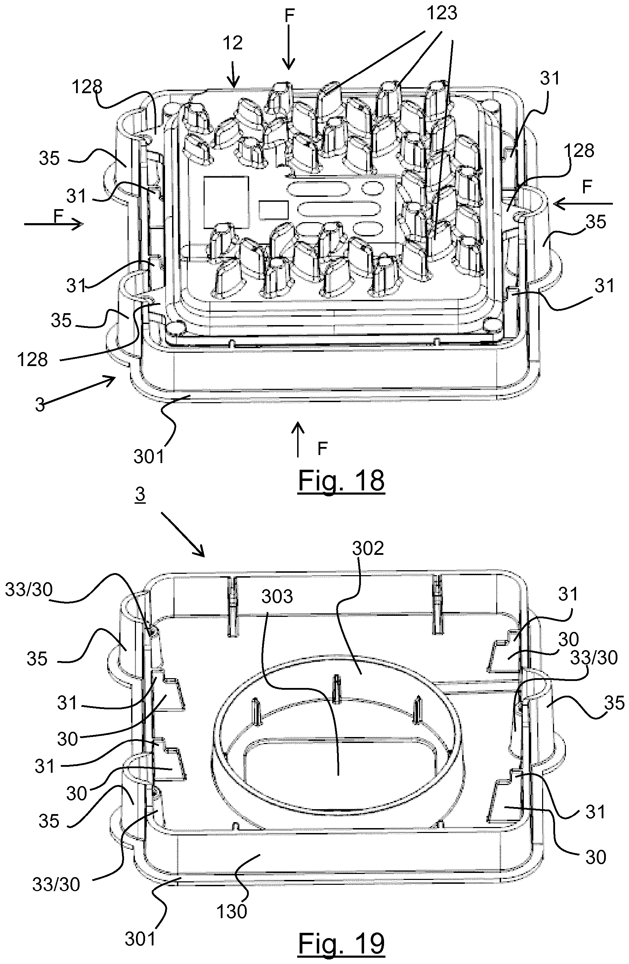

Dans un deuxième mode de réalisation non limitatif illustré sur les figures 18 à 20, le boîtier secondaire 3 comporte un muret de protection 130.

Ces éléments sont décrits en détail ci-après.

### ∘ Dispositif de guidage 31, 35

Le dispositif de guidage 31, 35 est adapté pour guider le boîtier 1 pour carte électronique 10 lors de son positionnement sur le boîtier secondaire 3.

Dans un premier mode de réalisation non limitatif illustré sur les figures 12 et 13, le dispositif de guidage comprend au moins une nervure 31. La nervure 31 présente une tranche 31'. Tel qu'illustré sur la figure 13, le capot de protection 11 du boîtier 1 est adapté à entrer en contact avec ladite tranche 31' pour être guidé par rapport au boîtier secondaire 3 jusqu'à ce qu'il vienne en appui sur le(s) dispositif(s) d'appui 30, 30'. Dans un exemple non limitatif illustré aux figures 12 et 13, le boîtier secondaire 3 comprend huit nervures 31. De cette manière, le capot de protection 11 est bien mis en position sur le boîtier secondaire 3 et on s'assure également que l'ouverture 111 de la cheminée primaire 115 arrive en vis-à-vis de l'ouverture 303 du boîtier secondaire 3.

Dans un deuxième mode de réalisation non limitatif illustré sur les figures 14 à 17, le dispositif de guidage comprend au moins une gouttière 35. Cette gouttière 35 se présente sous la forme d'une pièce arrondie. La gouttière 35 est adaptée pour guider une des pattes de fixation 128 du dissipateur thermique 12 en translation jusqu'à ce que le dissipateur thermique 12 vienne en appui sur le(s) dispositif(s) d'appui 30. Dans un exemple non limitatif illustré aux figures 14 à 17, le dispositif de guidage comprend trois gouttières 35.

Bien entendu, le premier mode de réalisation et le deuxième mode de réalisation peuvent être combinés ensemble tel qu'illustré sur les figures 18 à 20. Dans ce cas, le dispositif de guidage comprend au moins une nervure 31 et au moins une gouttière 35.

### ∘ Dispositif de fixation 33

Le dispositif de fixation 33 est adapté pour recevoir une vis 129 pour la fixation du boîtier 1 pour carte électronique 10 sur le boîtier secondaire 3.

Dans un mode de réalisation non limitatif, le dispositif de fixation 33 se présente sous la forme d'un fût. Dans un mode de réalisation non limitatif, la vis 129 est auto-formeuse.

Dans un exemple de réalisation non limitatif illustré sur les figures 12, 13 et 15, 16, et 18, le boîtier secondaire 3 comprend trois fûts 33.

Le dispositif de fixation 33 est agencé pour maintenir un espace entre le capot de protection 11 du boîtier 1 et le boîtier secondaire 3 de sorte à laisser passer le flux d'air F entre ledit capot de protection 11 et ledit boîtier secondaire 3, comme il est illustré notamment à la figure 17. A cet effet, le dispositif de fixation 33 comprend une hauteur h2 suffisante pour laisser passer le flux d'air F. Ce flux d'air F passe ainsi entre le capot de protection 11 et le corps de base 301 du boîtier secondaire 3. Le flux d'air F vient ainsi en contact du capot de protection 11. Ce dernier sert alors de dissipateur thermique pour la carte électronique 10, en particulier pour ses composants électroniques dont le composant électronique de pilotage. On notera que 20% à 30% de la chaleur dégagée par la carte électronique 10 peut alors être dissipée par le capot de protection 11.

Dans un mode de réalisation non limitatif illustré sur les figures 14 à 17, le dispositif de guidage en forme de gouttière 35 entoure le dispositif de fixation 33.

### ∘ Dispositif d'appui 30, 30'

Le dispositif d'appui 30, 30' est adapté pour recevoir le boîtier 1 pour carte électronique 10 lorsque celui-ci est fixé sur le boîtier secondaire 3.

Dans un premier mode de réalisation non limitatif illustré sur la figure 12, le dispositif d'appui comprend une nervure primaire 30 et une nervure secondaire 30'. La nervure primaire 30 prolonge le dispositif de guidage 31. La nervure primaire 30 présente une hauteur inférieure au dispositif de guidage 31. La nervure secondaire 30' prolonge le dispositif de fixation 33. La nervure primaire 30 et la nervure secondaire 30' présentent une hauteur sensiblement égale à celle h2 du dispositif de fixation 33. On obtient ainsi un double appui pour le boîtier 1. Un premier avec le dispositif d'appui 30, 30' et un second avec le dispositif de fixation 33 lorsque c'est un fût. Le premier appui permet de bien plaquer le capot de protection 11 sur le dissipateur thermique 12 pour assurer l'étanchéité CEM comme décrit ci-après. Le deuxième appui permet de ne pas trop déformer le capot de protection 11. Les nervures primaires 30 et secondaire 30' permettent d'avoir des points de contact sur le capot de protection 11, ce dernier étant en appui sur lesdites nervures primaire 30 et secondaire 30'.
Dans un mode de réalisation non limitatif illustré sur la figure 12 ou 18, le boîtier secondaire 3 comprend une pluralité de nervures primaires 30 (huit dans l'exemple non limitatif illustré), et secondaires 30' (deux dans l'exemple non limitatif illustré) réparties régulièrement sur le corps de base 301 du boîtier secondaire 3. Cela permet de bien plaquer le capot de protection 11 sur le dissipateur thermique 12 quand le boîtier 1 est assemblé au boîtier secondaire 3. Le capot de protection 11 est ainsi plaqué sur le dissipateur thermique 12 à intervalles réguliers ce qui assure une bonne étanchéité aux rayonnements électromagnétiques, appelée étanchéité CEM. Ainsi, les composants électroniques de la carte électronique 10 du boîtier 1 sont bien protégés contre des rayonnements électromagnétiques émis par les autres organes électroniques du véhicule automobile (appelés émissions CEM), et les autres organes électroniques sont bien protégés contre des rayonnements électromagnétiques émis par la carte électronique 10, en particulier par ses composants électroniques.

Dans un deuxième mode de réalisation non limitatif illustré sur la figure 15, le dispositif d'appui 30 est le dispositif de fixation 33 décrit précédemment. Le capot de protection 11 va en effet s'appuyer sur les fûts 33 décrits précédemment.

Bien entendu, le premier mode de réalisation et le deuxième mode de réalisation peuvent être combinés ensemble tel qu'illustré sur les figures 18 à 20. Dans ce cas, il y a au moins un dispositif d'appui qui comprend une nervure primaire 30 et une nervure secondaire 30' et au moins un dispositif d'appui qui est le dispositif de fixation 33.

On notera que la hauteur h2 correspond à la hauteur h1 de la cheminée secondaire 302 du boîtier secondaire 3 plus un jeu O1 (illustré sur la figure 17). Dans un exemple non limitatif, la hauteur h1 est sensiblement égale à 13,8mm (millimètres) et le jeu O1 est sensiblement égal à 0,5mm. La cheminée secondaire 302 est ainsi plus basse que le dispositif d'appui 30, 30'. On a ainsi un jeu O1 entre le capot de protection 11 et la cheminée secondaire 302 lorsque ledit boîtier 1 est assemblé sur le boîtier secondaire 3 et en particulier lorsque ledit boîtier 1 est en appui sur le(s) dispositif(s) d'appui 30, 30'. La cheminée secondaire 302 est ainsi plus basse que le capot de protection 11. Ainsi, lorsque le boîtier 1 est fixé sur le boîtier secondaire 3 via les dispositifs de fixation 33 et les vis 129, la cheminée secondaire 302 ne va pas toucher ni appuyer sur le capot de protection 11. Ce dernier ne va ainsi pas abîmer la carte électronique 10 du fait du vissage du boîtier 1 sur le boîtier secondaire 3.

### ∘ Muret de protection 130

Le muret de protection 130 est illustré sur les figures 18 à 20.

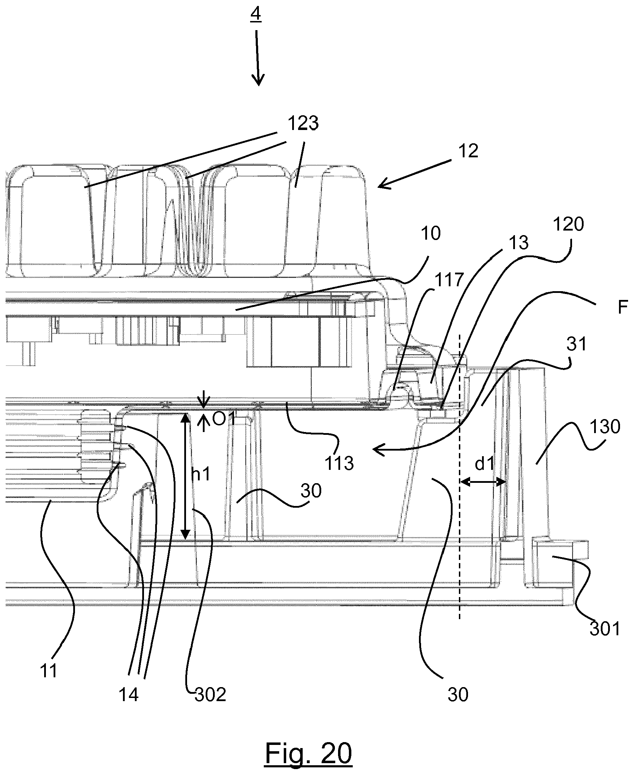

Le muret de protection 130 est adapté pour protéger le joint d'étanchéité secondaire 14 contre des agressions d'un fluide sous pression dans un exemple non limitatif. En effet, tel que décrit précédemment, il existe un jeu O1 illustré sur la figure 20 entre la cheminée 302 du boîtier secondaire 3 et la plaque de base 113 du capot de protection 11. Par conséquent, un fluide sous pression pourrait s'engouffrer entre le boîtier secondaire 3 et le capot de protection 11 (en particulier sa plaque de base 113) et abîmer ledit joint d'étanchéité secondaire 14.

Le muret de protection 130 se trouve à distance du pourtour 121 du dissipateur thermique 12. Cela permet à un flux d'air F de s'engouffrer entre le boîtier secondaire 3 et le capot de protection 11 de sorte à être en contact avec ledit capot de protection 11 (en particulier sa plaque de base 113). La dissipation thermique de la carte électronique 10 est ainsi toujours assurée par ledit capot de protection 11, ce dernier n'étant pas confiné. Dans un exemple non limitatif, le muret de protection 130 se trouve à une distance d1 comprise entre 5mm et 10mm du pourtour 121 du dissipateur thermique 12. Cette plage de valeurs permet à un flux d'air F de s'engouffrer correctement entre le boîtier secondaire 3 et le capot de protection 11.

Ainsi, en supprimant le muret de protection sur le boîtier secondaire 3 de l'état de la technique antérieur selon le premier mode de réalisation illustré sur les figures 1 à 17, et en le remplaçant par un dispositif de protection (muret 120 et/ou bord tombé 110) sur le boîtier 1 pour carte électronique 10, cela permet :
- de continuer à assurer l'étanchéité du boîtier 1 en protégeant notamment le joint d'étanchéité primaire 13 ; et
- de ne plus confiner le composant électronique de pilotage de la carte électronique 10 par un muret de protection côté boîtier secondaire 3 ;
- de laisser passer un flux d'air F à l'intérieur de l'assemblage 4, à savoir entre le capot de protection 11 et le boîtier secondaire 3 de sorte que ce flux d'air F vienne en contact avec ledit capot de protection 11. Le capot de protection 11 est ainsi aéré et il est refroidi par le flux d'air F et il sert ainsi également de dissipateur thermique.
On notera que dans le cadre de l'application d'un dispositif lumineux, on peut abaisser la température du boîtier sensiblement de 7°C par rapport à l'état de la technique antérieur qui comprend un muret de protection sur le boîtier secondaire 3 disposé à quelques dixièmes de millimètre du dissipateur thermique 12.

Ainsi, outre le dispositif de protection (muret 120 et/ou bord tombé 110) sur le boîtier 1 pour carte électronique 10, en ajoutant le muret de protection 130 sur le boîtier secondaire 3 à distance du dissipateur thermique 12 selon le deuxième mode de réalisation illustré sur les figures 18 à 20, cela permet :
- d'assurer l'étanchéité de l'assemblage 4 en protégeant notamment le joint d'étanchéité secondaire 14 ; et
- de ne plus confiner le composant électronique de pilotage de la carte électronique 10 par un muret de protection côté boîtier secondaire 3 qui colle au dissipateur thermique 12 ;
- de laisser passer un flux d'air F à l'intérieur de l'assemblage 4, à savoir entre le capot de protection 11 et le boîtier secondaire 3 de sorte que ce flux d'air F vienne en contact avec ledit capot de protection 11. Le capot de protection 11 est ainsi aéré et il est refroidi par le flux d'air F et il sert ainsi également de dissipateur thermique.
On notera que dans le cadre de l'application d'un dispositif lumineux, on peut abaisser la température du boîtier sensiblement de 6°C par rapport à l'état de la technique antérieur qui comprend un muret de protection sur le boîtier secondaire 3 disposé à quelques dixièmes de millimètre du dissipateur thermique 12.

Bien entendu, la description de l'invention n'est pas limitée aux modes de réalisation décrits ci-dessus.
Ainsi dans un mode de réalisation non limitatif, le nombre de dispositif de fixation 128 du dissipateur thermique 12 est supérieur à trois.

Ainsi, l'invention décrite présente notamment les avantages suivants :
- elle protège efficacement le joint d'étanchéité primaire 13 du boîtier 1 pour carte électronique 10 contre des agressions externes audit boîtier 1, notamment contre des agressions d'un fluide sous pression ;
- elle protège efficacement le joint d'étanchéité secondaire 14 du boîtier 1 pour carte électronique 10 contre des agressions externes audit boîtier 1, notamment contre des agressions d'un fluide sous pression ;
- elle empêche tout fluide de s'infiltrer dans le boîtier 1 ce qui protège notamment le composant électronique de pilotage de la carte électronique 10 ;
- elle améliore la dissipation thermique du boîtier 1 pour carte électronique 10 en laissant passer un flux d'air F entre le capot de protection 11 du boîtier 1 et le boîtier secondaire 3. Elle permet ainsi au capot de protection 11 d'avoir également la fonction de dissipation thermique ;
- les émissions CEM du boîtier 1 pour carte électronique 10 sont limitées ;
- elle permet de protéger le boîtier 1 pour carte électronique 10 contre des émissions CEM d'autres organes du véhicule automobile ; et
- l'assemblage des différentes parties composant le dispositif lumineux est facilité.

## Revendications

1. Boîtier (1) pour carte électronique (10) pour dispositif lumineux pour véhicule automobile, ledit boîtier (1) comportant :
- un capot de protection (11) adapté pour être disposé sur un dissipateur thermique (12) ;
- ledit dissipateur thermique (12) adapté pour accueillir ladite carte électronique (10) ;
- un joint d'étanchéité primaire (13) disposé entre ledit capot de protection (11) et ledit dissipateur thermique (12) à proximité du pourtour (121) du dissipateur thermique (12) ; et
- un dispositif de protection (110, 120) dudit joint d'étanchéité primaire (13).

2. Boîtier (1) selon la revendication 1, dans lequel ledit capot de protection (11) comprend une ouverture (111) du côté opposé au dissipateur thermique (12) de sorte à recevoir un connecteur (16, 161, 162).

3. Boîtier (1) selon la revendication 2, dans lequel ledit capot de protection (11) comprend un joint d'étanchéité secondaire (14) disposé côté de ladite ouverture (111).

4. Boîtier (1) selon l'une quelconque des revendications 1 à 3, dans lequel ledit dispositif de protection comprend au moins un muret (120) agencé sur au moins une partie du pourtour (121) dudit dissipateur thermique (12).

5. Boîtier (1) selon la revendication 4, dans lequel ledit au moins un muret (120) affleure ou dépasse du capot de protection (11).

6. Boîtier (1) selon l'une quelconque des revendications 1 à 5, dans lequel ledit dispositif de protection comprend un bord tombé (110) agencé sur ledit capot de protection (11) et adapté pour reposer sur au moins une partie du pourtour (121) dudit dissipateur thermique (12).

7. Boîtier (1) selon l'une quelconque des revendications 1 à 6, dans lequel ledit dissipateur thermique (12) et/ou ledit capot de protection (11) est plan ou comprend des protubérances (123).

8. Dispositif de pilotage (2) de l'alimentation électrique pour au moins une source lumineuse pour dispositif lumineux, dans lequel ledit dispositif de pilotage (2) comprend un boîtier (1) selon l'une quelconque des revendications précédentes 1 à 7 et une carte électronique (10) logée dans ledit boîtier (1).

9. Assemblage (4) pour dispositif lumineux pour véhicule automobile comprenant un boîtier (1) pour carte électronique (10) selon l'une quelconque des revendications 1 à 7 assemblé avec un boîtier secondaire (3) pour dispositif lumineux.

10. Assemblage (4) selon la revendication 9, dans lequel ledit boîtier secondaire (3) comprend au moins un dispositif de fixation (33) pour ledit boîtier (1).

11. Assemblage (4) selon la revendication 9 ou la revendication 10, dans lequel ledit boîtier secondaire (3) comprend au moins un dispositif d'appui (30, 30') pour ledit boîtier (1).

12. Assemblage (4) selon l'une quelconque des revendications 9 à 11, selon lequel ledit boîtier secondaire (3) comprend au moins un dispositif de guidage (31, 35) pour ledit boîtier (1).

13. Assemblage (4) selon l'une quelconque des revendications 9 à 12, selon lequel ledit boîtier secondaire (3) comprend un muret de protection (130) disposé à distance (d1) du pourtour (121) dudit dissipateur thermique (12) du boîtier (1) pour carte électronique (10).

14. Assemblage (4) selon la revendication 13, selon lequel ledit muret de protection (130) se trouve à une distance (d1) comprise sensiblement entre 5mm et 10mm du pourtour (121) du dissipateur thermique (12).

15. Dispositif lumineux pour véhicule automobile, dans lequel ledit dispositif lumineux comprend :
- au moins une source lumineuse adaptée pour produire des rayons lumineux ;
- un module optique adapté pour coopérer avec lesdits rayons lumineux de ladite au moins une source lumineuse ;
- un boîtier (1) pour carte électronique selon l'une quelconque des revendications précédentes 1 à 7 ;
- une carte électronique (10) logée dans ledit boîtier (1) ; et
- un boîtier secondaire (3) adapté pour être assemblé avec ledit boîtier (1) pour carte électronique.

16. Dispositif lumineux selon la revendication 15, dans lequel ladite au moins une source lumineuse fait partie d'une diode électroluminescente.
